(19) Europäisches Patentamt
European Patent Office
Office européen des brevets

(11) **EP 2 521 192 B1**

(12) **EUROPEAN PATENT SPECIFICATION**

(45) Date of publication and mention
of the grant of the patent:
**09.07.2014   Bulletin 2014/28**

(51) Int Cl.:
*H01L 35/32* (2006.01)        *H01L 35/34* (2006.01)

(21) Application number: **12162646.9**

(22) Date of filing: **30.03.2012**

(54) **Seebeck/Peltier thermoelectric conversion device employing a stack of alternated nanometric layers of conductive and dielectric material and fabrication process**

Thermoelektrisches Seebeck/Peltier-Umwandlungselement mit einem Stapel aus abwechselnden nanometrischen Schichten aus leitendem und nichtleitendem Material, und Herstellungsprozess

Dispositif de conversion thermoélectrique Seebeck/Peltier utilisant une pile de couches nanométriques alternées de matériau conducteur et diélectrique et procédé de fabrication

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **04.05.2011   IT MI20110751**

(43) Date of publication of application:
**07.11.2012   Bulletin 2012/45**

(73) Proprietor: **Consorzio Delta Ti Research
20124 Milano (IT)**

(72) Inventors:
• **Narducci, Dario
20126 Milano MI (IT)**
• **Cerofolini, Gianfranco
20126 Milano Mi (IT)**

(74) Representative: **Pellegri, Alberto et al
Società Italiana Brevetti S.p.A.
Via Carducci, 8
20123 Milano (IT)**

(56) References cited:
**WO-A2-2009/125317**

**Description**

BACKGROUND

Technical field

The disclosure relates in general to Seebeck/Peltier effect thermoelectric conversion devices and in particular to devices using layers of conductive or semi conductive material deposited over a substrate even of large size by common planar techniques and with electrical contacts definable with noncritical lithographic or serigraphic techniques.

Reference notions

The Seebeck effect is a thermoelectric phenomenon according to which a difference of temperature at the opposite ends of an elongated conductor or semiconductor generates electricity. The effect, discovered by the physicist Thomas J. Seebeck in 1821, manifests itself with the presence of a voltage difference at the two ends of a conductive bar subjected to a gradient of temperature $\nabla T$. In a circuit including two junctions kept at different temperatures $T_1$ and $T_2$, between different materials A and B the voltage difference between the two junctions is given by:

$$V = \int_{T_1}^{T_2} \left[ S_B(T) - S_A(T) \right] dT \qquad (1)$$

where: $S_A$ and $S_B$ are the Seebeck coefficients (also referred to as thermoelectric powers) relative to the two materials A and B. The voltage values are typically in the order of few $\mu$V/K. The Seebeck coefficients depend from the materials, from their absolute temperature and from their structure. The Seebeck effect may be exploited for making devices adapted to measure temperature differences, in terms of voltage differences in a circuit constituted by wires of different materials (thermocouple) or for generating electrical energy (thermopile) by connecting in series a certain number of thermocouples.

From a microscopic point of view, the charge carriers (electrons in metals, electrons and holes in semiconductors, ions in ionic conductors) diffuse when one end of the elongated conductor is at a temperature different from the temperature at the other end. The carriers at higher temperature will diffuse toward the zone at a lower temperature as long as there are different densities of carriers in the portion at lower temperature and in the portion at higher temperature of the elongated conductor. In an isolated system, equilibrium will be reached when, through a diffusion process, heat will become uniformly distributed along the whole conductor. Redistribution of thermal energy due to the movement of charge carriers contemplates a thermal current and of course such an electrical current will become null when the temperature of the system becomes uniform. In a system where two junctions are kept at a constant difference of temperature, also the thermal current will be constant and therefore a constant flux of charge carriers will be observed. Carrier mobility is reduced by scattering phenomena caused by impurities present in the lattice of the material, by structural defects and by lattice vibrations (phonons). Therefore, the Seebeck coefficient of a material depends in a significant measure on the density of impurities and of crystallographic defects beside from the phonon spectrum in the material. On the other end, locally phonons are not always in thermal equilibrium. On the contrary they move following the temperature gradient and loose energy by interacting with electrons or other carriers, as well as with the lattice defects. If the phonon-electron interaction is predominant, the phonons will tend to push electrons toward a portion of the elongated conductor loosing energy in the process, thus contributing to the electric field in the conductor film. These contributions are ever more important in the temperature range to which the phonon-electron scattering phenomenon is predominant, that is for

$$T \approx \frac{1}{5} \theta_D \qquad (2)$$

where $\theta_D$ is the Debye temperature. At temperatures lower than $\theta_D$ there are fewer phonons that are available for energy transfer while at temperatures above $\theta_D$ they tend to lose energy through a sequence of phonon-phonon collisions rather than through repeated phonon-electron collisions.

It is useful to define a thermoelectric factor of merit of a material as:

$$Z = \frac{S'^2}{\kappa \rho} \qquad (3)$$

where $\kappa$ and $\rho$ are the heat conductivity and the electrical resistivity, respectively, of the material.

From a technological point of view, the use of Seebeck/Peltier effect thermoelectric converters has being considered for potentially important commercial application. More than half of the heat generated in a thermoelectric power plant is at present dissipated as low enthalpy heat. It is estimated that about 15 millions of megawatt are dispersed in the process of energy conversion alone. Availability of Seebeck generators capable of converting even only part of such amount of low enthalpy heat in electricity would have a significant positive impact on the energy shortage problem.

Known candidates as thermoelectrically active materials generators have a rather low factor of merit. For example, in case of a thin film of $n$ silicon, doped with $5 \times 10^{15}$ atoms of As per $cm^3$, at room temperature, $Z \approx 10^{-3}$ $K^{-1}$. Values of $ZT \approx 1$ may be obtained only with costly materials of scarce availability such as $Bi_2Te_3$ or alloys of Sb or Se, as an example. In practice, besides few uses at relatively high added value, such as for thermoelectric generation in spacecrafts, the thermoelectric generators based on massive low cost materials achieve conversion yields of the thermal power to electrical power of just about 7%. By comparison, a turbine engine is capable of converting about 20% of the thermal energy to electrical energy.

In order to increase the factor of merit, the numerator should be maximized and/or the denominator should be minimized in Eq. (3).

Analyzing the denominator, the formula may be written as:

$$Z = \frac{S^2}{\rho\left(\kappa_{ph} + \kappa_{el}\right)} = \frac{S^2}{\rho\kappa_{ph} + LT}$$

where

$$L = \frac{\rho\kappa_{el}}{T} = \frac{\pi^2}{3}\left(\frac{k_B}{q}\right)^2$$

and where $-q$ is the electron charge and the suffixes $ph$ and el indicate pertinence to phonons and to electrons, respectively.

According to Wiedemann-Franz Law, $L$ is almost a universal constant of about $2.44 \times 10^{-8}$ $W\Omega K^{-2}$, because in metals the ratio between heat and electrical conductivities ($\sigma = 1/\rho$) is almost the same at the same temperature $T$.

For a good thermoelectric material $\kappa_{el}$, that is $LT/\rho$, should always be much less than $\kappa_{ph}$. That is to say that heat conduction should not be dominated by the contribution attributed to the heat conductivity of electrons.

Therefore, the doping of a semiconducting material destined to be used in Seebeck effect devices must be adapted to ensure a high electrical conductivity without significantly affecting heat conductivity.

Analyzing the numerator one has

$$S = \frac{k_B}{q}\left(\frac{5}{2} - \ln\left(\frac{N_d}{N_{V-C}}\right)\right) = \frac{k_B}{q}\left(\frac{5}{2} + \ln\left(q\mu\rho N_{V-C}\right)\right)$$

where $N_{V-C}$ is the density of states in the appropriate band depending on the dopant used and $N_d (= 1/q\mu\rho)$ is the active dopant concentration.

Therefore, though $S$ varies with resistivity, it does so logarithmically (that is at a much reduced rate).

Discussion of the prior art

Lately it has been shown [1, 2] how a system of drastically reduced size (nanowires of silicon with transversal dimensions in the order of 20 nm) and having suitably roughened surfaces, may manifest a relatively high thermoelectric factor of merit. Enhancement of the Z factor derives from a "decoupling" between the mean free path figures of phonons and electrons caused by a significant scattering of phonons at the surface of the conductive nanowire. In particular, the important contribution to heat conductivity deriving from acoustic phonons of relatively lower frequency (longer wavelength) may be almost completely eliminated, being null in the material the density of phonons of wavelength greater than the cross section dimensions of the wire. As a consequence, the heat conductivity of silicon drops from $\approx$ 150 W m$^{-1}$ K$^{-1}$ (at room temperature for massive Si) to $\approx$ 1.6 W m$^{-1}$ K$^{-1}$ (at room temperature for nanowires of Si of 20 nm in cross section). Unfortunately, these test devices made with silicon nanowires are made with techniques unsuitable to industrialization on large scale.

In a prior published patent applications No. WO 2009/125317 and in prior Italian patent application No. VA2009A000082, filed on December 15, 2009, of the same applicant, methods are described for making nanowires of elements belonging to the IV Group of the Periodic Table or of alloys thereof, without requiring the use of advanced lithographic techniques of definition, in the realm of few tens of nanometers, and with a great control of the surface roughness of the nanowires, adapted to modify the mean free paths of phonons and electrons by exploiting even cavity surfaces produced in a controlled manner within the bulk of the nanowires. The disclosed processes though much simpler than the fabrication processes previously used for making nanosized elongated structures, still requires lithographic processing, anisotropic etchings and conformal deposition processes in vacuum.

In prior Italian patent application No. VA2009A000050, filed on July 15, 2009, of the same applicant, a conversion device is described made of a stack of dielectric layers alternated to semiconducting layers even of large area that after deposition are implanted with ions of a noble gas or with N, F, or O, at gradually varied kinetic energy and fluence, and successively subjected to a degassing treatment though thermal cycling for favoring gaseous molecular aggregations within the bulk of the semiconductor that cause formation of nanocavities, uniformly distributed in the material, before being eventually released off in part.

## GENERAL DESCRIPTION OF THE INVENTION

Theoretical analyses, confirmed by preliminary laboratory tests conducted by the applicant have verified a substantial confinement of phonons (thermal current) migrating in a bi-dimensional nanometric structure. With this definition we intend a structure whose thickness $h$ does not exceed 100 nm, and whose width $w$ and length $l$ exceed significantly (e.g., by one or more orders of magnitude) the thickness $h$. In bi-dimensional nanometric structure of heat-conductive material the heat-escape area, $wh$, is small enough to prevent direct escape paths across the planar surfaces. When this basic condition is coupled to that of making the escape surfaces not smooth and substantially parallel to the direction of the temperature gradient across a septum, but relatively rough that is with nanometric profile irregularities adapted to contrast migration of reflected phonons in the direction of the temperature gradient across a septum by enhanced net backward inelastic scattering at the surface, a remarkably incremented thermoelectric factor of merit is observed.

Surface irregularities with mean peak-to-valley amplitude and mean periodicity comprised between 5 to 20 nm are outstandingly effective.

According to a first embodiment, a stack of films of these characteristics, alternated to dielectric films of electrical insulation between the nanometric electrically conductive films of directional confinement of a thermal current (phonons migrating from a hot side toward a cool side of the conductive films or vice versa in case of operation of the device as heat pump) constitutes a surprisingly efficient Seebeck-Peltier effect electrically conductive septum, apt to support thermo-electrical energy conversion.

A septum of size suitable for practical real world applications may be fabricated without requiring any lithographic or serigraphic definition steps to create parallel conduction paths of nanometric size, by simply repeating sequential formation of a layer of conductive material of thickness generally comprised between a few nanometers and several tens of nanometers, and of a dielectric layer of similar nanometric thickness or even smaller, preferably comprised between a few nanometers and 50 nanometers, until reaching the desired thickness (height) of the so grown stack.

Suitable conductive materials are metals such as for example aluminum, titanium, tantalum, molybdenum, tungsten, nickel, or semiconductors such as doped silicon, germanium or alloys thereof. Suitable dielectric materials are oxides of the conductive materials.

Metal coated opposite sides of a septum (that may be a slice of desired thickness of the grown stack) of such alternately stacked conductive and dielectric layers, constitute connectable terminals of the conversion device and would coincide with the hot and cool sides, respectively, of the septum.

Deposition of nanometric conductive layers of irregular (rough) surfaces may be achieved by intermittent "breaks" of air or other oxidizing gas into the hot chamber of deposition of the conductive material with a common CVD or LP-CVD technique. Oxidation of a surface portion of the deposited conductive material during such air breaks disrupts the relative planarity of the deposited conductor or semiconductor producing a rough interface of oxidation of the conductive substrate and a similarly roughened surface of the grown oxide layer.

Over such rough surface of the first dielectric oxide layer, deposition by CVD or LP-CVD of a second nanometric layer of electrically conductive material is resumed that replicates to some extent the underlying roughness of the surface of the first oxide layer.

With a successive air break a second electrically insulating layer is formed on the irregular surface of the deposited second conductive layer by oxidizing part of the thickness of the deposited material as done for the first dielectric oxide layer and the two-step cycle of deposition and oxidation may be repeated as many time as necessary to grow a stack of alternated layers of the desired thickness (height).

Alternatively, over the first deposited nanometric conductive layer and after fluxing the deposition chamber with $N_2$ or other non reactive gas, a layer of sub-stoichiometric oxide of thickness generally comprised between a few nanometers and 40 nanometers may be deposited by feeding a heat decomposable precursor compound of dielectric oxide. The successive pyrolitic decomposition and formation of dielectric oxide over the substrate is a process that produces surface irregularities with mean peak-to-valley amplitude and mean periodicity comprised between 5 to 20 nm. The successively deposited conductive layer conforms to the surface irregularities of the deposited layer pyrolitically converted to dielectric oxide, constituting an interface having the desired morphology, that is with irregularities of mean peak-to-valley amplitude and mean periodicity comprised between 5 to 20 nm. The surface of the deposited conductive layer will substantially replicate the root roughness notwithstanding a non negligible planarizing characteristic of a LP-CVD deposition of the conductor. Thereafter, with the replication of these alternated deposition steps of conductive and dielectric layers a stack of the desired height is fabricated.

The roughening produced by the deposition of the oxide layer will be counterbalanced by the smoothing produced by the deposition of the conductor, so that after a certain number of layers the multilayered film will attain a more or less constant roughness.

An alternative and effective embodiment of the applicants' intuition that an effective confinement or impediment to an otherwise detrimental unrestrained migration of phonons along the direction of the temperature gradient without necessarily restricting cross sectional dimensions to few units or tens of nanometers, implies minor changes to the above described process of alternate formation of conductive and dielectric oxide layers.

In practice, according to this alternative embodiment, accepting the fact that electrical insulation between deposited conductive films by an uninterrupted layer of dielectric oxide may be lost, a layer of sub-stoichiometric oxide of reduced thickness, for example in the order of a few nanometers, is formed over the surface of a deposited nanometric layer of conductive material, preferably also of reduced thickness, for example in the order of 1 to 5 nanometers. A layer of a few nanometers of sub-stoichiometric oxide may be obtained with any known technique such as, for example, by exposing to air at room temperature the just deposited conductive material or sub-stoichiometric oxide may be deposited by feeding into the CVD or LP-CVD deposition chamber a suitable precursor compound. Once a stack of many conductive layers alternated to layers of sub-stoichiometric oxide, is completed, it is heat treated at a temperature generally in the range of 600 to 900 °C, causing the decomposition of the metastable sub-stoichiometric oxide to the respective element (X) and stoichiometric dielectric oxide, for example according to the following reaction:

$$i\mathrm{XO}_x \rightarrow (i\text{-}x)\mathrm{X} + x\mathrm{XO}_i$$

$i$ being an integer number and $x$ a fractional value. In the case of Si, the previous reaction takes the specific form

$$\mathrm{Si}_{1+x}\mathrm{O}_2 \rightarrow x\mathrm{Si} + \mathrm{SiO}_2$$

The pyrolitically formed stoichiometric oxide tends to form clusters of nanometric and sub-nanometric sizes that preferentially nucleate at boundaries among the crystalline grains of the conductive substrate layer.

This mechanism coupled to the fact that even layers of $\mathrm{XO}_x$ with mean thickness of a few nanometers (e.g. 1 to 3 nm) are capable of forming such dielectric nanoparticles of $\mathrm{XO}_i$, leads to the constitution of a no longer neatly stratified structure but to an X matrix having parallel spaced regions or layers in which is observable a densely dispersed population of nanometric and sub-nanometric particles and clusters of particles of dielectric oxide $\mathrm{XO}_i$, in a spatial concentration sufficient to make almost inevitable the impact of a phonon with a particle whichever its direction of motion in the X matrix.

The final pyrolitic treatment for converting the sub-stoichiometric oxide film to a population of dielectric clusters of stoichiometric oxide relieves mechanical stresses intrinsic to the stacking of alternately deposited layers of different materials. Moreover, such a deliberate loss of electrical insulation among the stacked conductive nanolayers of deposited metallic or semiconductor material avoids possible unbalances of internal electrical resistance across the septum and attendant power losses that may arise with a layered stack of alternated, uninterrupted layers of conductive and of dielectric material. At the same time, substantial confinement of migrating phonons in the conductive layers alternated to the dielectric oxide-rich layers is retained.

According to a layered embodiment, the Seebeck/Peltier thermoelectric conversion device comprises a stack of nanometric films of a polycrystalline conductive or semiconductive material having bulk resistivity value equal to or less than $10^{-2}$ $\Omega$cm, mean thickness of about 15 to about 50 nm, electrically insulated from one another by a thermally grown dielectric oxide layer.

Nanometric layers with the above characteristics may preferably be of a common semiconductor, generally of doped silicon, doped germanium or alloys thereof, deposited by chemical deposition from vapor phase (CVD, LP-CVD) and similar deposition processes that are generally known to produce a relatively planarizing deposit, the nanometric surface roughness of which may be indirectly provided by the way dielectric film of thermally grown or deposited dielectric oxide are formed on the deposited conductive layers, and eventually treated for creating the required nanometric roughness of the interface conductor/dielectric or dispersion of the dielectric in a layer of nanometric and sub-nanometric clusters.

The invention is defined in the annexed claims, the recitation of which is intended to form part of this description by express reference.

BRIEF DESCRIPTION OF DRAWINGS

Figure 1 is an idealized fragment cross section of a multilayered stack suitable for constituting a Seebeck/Peltier effect electrically conductive septum, according to a first embodiment of this disclosure.

Figure 2 is an idealized fragment cross section of a multilayered stack suitable for constituting a Seebeck/Peltier effect electrically conductive septum according to an alternative embodiment of this disclosure.

EXEMPLARY EMBODIMENTS

The exemplary embodiments presented herein below have an exclusively illustrative purpose and are not intended to limit the invention that can be practiced by any expert of the field even by modifying the deposition-oxidation processes or use different conductive or semiconducting materials and different dielectric materials.

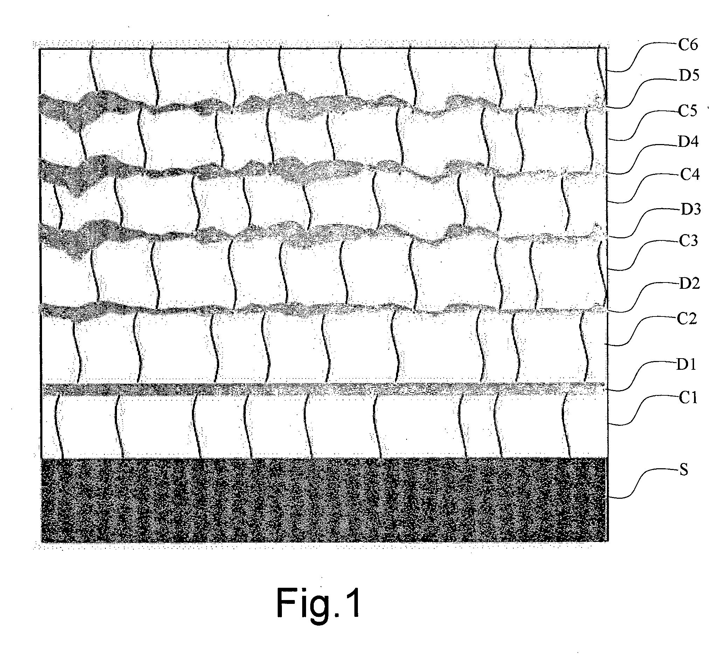

Referring to **FIG. 1,** in building a multilayered stack of this invention, one may start depositing a first electrical conductive layer of doped silicon C1 of nanometric thickness over a substantially flat dielectric substrate S, for example a planar glass sheet, by vapor phase (CVD or LP-CVD) feeding in an low-pressure, heated deposition chamber silane ($SiH_4$) and a suitable dopant compound such as $PH_3$, $AsH_3$ or $B_2H_6$, diluted in $N_2$, at a temperature in the range of 600-800°C.

Such a first nanometric layer C1 of doped silicon semiconductor may have a substantially uniform thickness of about 40-50 nm with little or no surface roughness.

Thereafter, after fluxing the deposition chamber with $N_2$, oxygen or $N_2O$ is fed to the chamber, kept at the same temperature, in the order of about 20-30 minutes, for growing a relatively rough layer of substantially stoichiometric oxide ($SiO_2$) having a mean thickness of about 20-30 nm. Alternatively, a rough layer of substantially stoichiometric oxide ($SiO_2$) having a mean thickness of about 20-30 nm may be deposited by feeding into the $N_2$ fluxed chamber tetraoxysilicate, the pyrolitic decomposition of which forms a rough dielectric layer D1 onto the conductive nanolayer C1 of substrate.

Alternation of these steps of deposition of a nanometric layer of doped silicon, C1, C2, C3, ... etc., followed by oxidation or deposition of a rough nanometric dielectric layer, D1, D2, D3, ... etc., quickly produces, by additive roughening effect, in practice non smooth semiconductor/oxide interfaces with surface irregularities having mean peak-to-valley amplitude and mean periodicity generally comprised between 5 and 20 nm.

Such a two-step cycle of deposition from vapor phase of a nanometric layer $C_i$ of conductor or semiconductor material followed by thermal oxidation with "air breaks" in the hot deposition chamber or by deposition of a dielectric to form a dielectric layer $D_i$ having nanometric roughness, is repeated as many times as necessary up to build a stack of desired height.

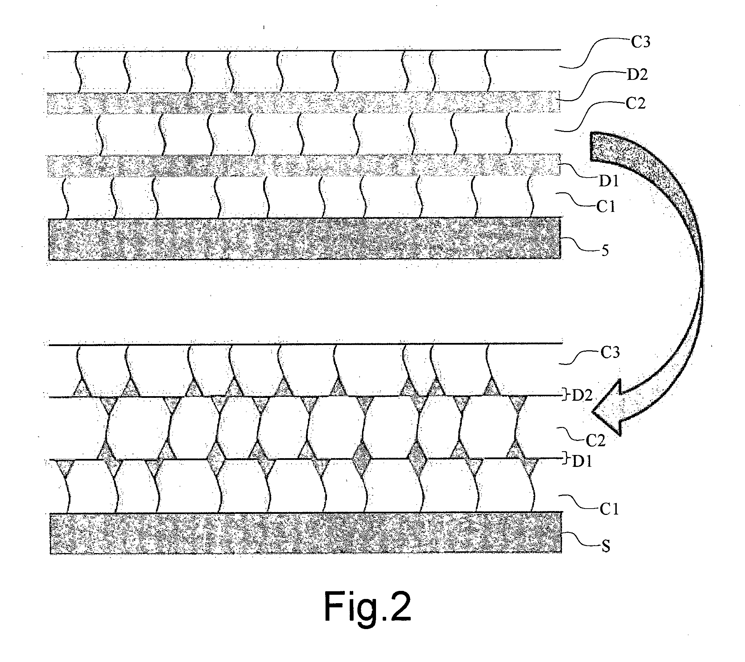

According to an alternative process, depicted in **FIG. 2,** the conditions of oxidation or of deposition of the layers, D1, D2, ...,. etc., are modified in order to form a layer of sub-stoichiometric oxide, preferably of reduced thickness, for example with a mean value limited to about 1 to 5 nm, over the surface of a deposited nanometric layer, C1, C2, C3, ..., etc., of conductive material, also of reduced thickness, for example with a mean value limited to about 10-20 nm.

A layer of few nanometers of sub-stoichiometric oxide may be obtained with any practical known technique such as, for example, by exposing to air at room temperature the just deposited conductive material. A tunnel oven comprising a plurality of deposition chambers with intervening (alternated) connecting chambers in which the stack being fabricated can be exposed to air at room temperature (15-40 °C) would be an efficient design choice for mass production.

Alternatively, an equivalent layer of few nanometers of sub-stoichiometric oxide may be deposited as contemplated in the above described exemplary first embodiment by reducing the times of deposition to few minutes and eventually diluting the $O_2$ or $N_2O$ feed and/or reducing the temperature in the deposition chamber during the deposition of oxide from a decomposable precursor compound, for example tetraoxysilicate to form a silicon sub-oxide ($SiO_{(2-y)}$).

Once a stack of many conductive layers alternated to layers of sub-stoichiometric oxide, is completed, it is heat treated at a temperature generally in the range of 600 to 900 °C, causing decomposition of any metastable sub-stoichiometric oxide that may have not decomposed during the repeated phases of deposition at generally higher temperature of deposition of the respective metal and stoichiometric dielectric oxide, for example in case of polycrystalline silicon according to the following reaction:

$$2SiO_x \rightarrow (2\text{-}x)Si + xSiO_2$$

The pyrolitically formed stoichiometric silicon oxide tends to form dielectric clusters that preferentially nucleate at boundaries among the crystalline grains of the conductive substrate layer, as schematically illustrated in **FIG. 2.**

The final pyrolitic treatment for converting the deposited film of sub-stoichiometric oxide to a layer region containing a population of dielectric clusters of stoichiometric oxide, relieves any mechanical stresses that may have accumulated during the stacking process of alternately deposited nanolayers of different solid materials.

Precursor compounds usable for CVD deposition of nanometric electrically conductive layers are, for example: $SiH_4$, $SiH_nCl_{4\text{-}n}$ (with n=1, 2, 3), $GeH_4$, $GeH_nCl_{4\text{-}n}$ (with n=1, 2, 3), for the substrates and $PH_3$, $POCl_3$ and $B_2H_6$ for their doping.

Fully grown multilayered stacks of this disclosure may be sliced to form Seebeck-Peltier active septa of desired thickness and size.

Metal layers of electrical connection may be formed on opposite side surfaces of the stack or of a stack slice, in order to connect all the nanometric conductive layers to an external circuit, either all in parallel or in a series of groups of layers in parallel.

In other words, the deposited metals of electrical connection over opposite ends of the stack may connect in parallel all the treated semiconductor layers of the stack or be patterned in order to define a plurality of groups of layers that are connected in parallel. The groups of layers may then be connected in series by electrical wires welded to a metal layer on a first end side of the stack and to an offset metal of a different group of parallel connected layers on the opposite end side of the stack, forming a series-parallel network of groups of layers, eventually connected, through two end terminals of the device, to the external circuit.

To this end, also the flanks of the parallelepiped stack or slice thereof may be coated with a passivating dielectric layer over which conductive stripes of a deposited metal layer may be defined for connecting in series distinct groups of treated semiconductor layers connected in parallel to each other by conductive stripes of metal defined on the opposite end sides of the stack.

Prior published patent application No. WO2009/125317 and International Application No. PCT/EP2010/069531 of the same applicant disclose such series-parallel electrical interconnection schemes, the description and illustrations of which are to be intended herein incorporated by express reference.

**Claims**

1.  A multilayered stack useful for constituting a Seebeck-Peltier effect electrically conductive septum with opposite hot-side and cold-side metallizations for connection to an electrical circuit, comprising a stacked succession of layers of electrically conductive material alternated to dielectric oxide layers in form of a continuous film or of densely dispersed nano and sub-nano particles or clusters of particles of oxide, at least said electrically conductive layers having mean thickness ranging from 5 to 100 nm and surface irregularities at the interfaces with the dielectric oxide layers of mean peak-to-valley amplitude and mean periodicity comprised between 5 to 20 nm.

2.  The multilayered stack of claim 1, wherein said electrically conductive material is a doped semiconductor belonging to the group composed of Si, Ge and alloys thereof.

3.  The multilayered stack of claim 1, wherein said electrically conductive material is doped polycrystalline silicon and said dielectric oxide layer is an oxidized surface portion of the doped polycrystalline.

4.  The multilayered stack of claim 1, wherein said electrically conductive material is doped polycrystalline silicon and said dielectric oxide is a sub-oxidized surface portion of the doped polycrystalline silicon successively pyrolitically decomposed to metallic silicon and dielectric silicon oxide.

5. A process for fabricating a multilayered stack useful for constituting the Seebeck-Peltier effect electrically conducting septum of claim 1, comprising the steps of

a) depositing with a CVD technique a polycrystalline conductor to form a first electrically conductive layer of mean thickness comprised between 5 and 100 nm on a substrate;
b) oxidizing the deposited polycrystalline conductor by heating at about 1000°C in oxygen to promote irregular growth of a layer of mean thickness comprised between 5 and 40 nm of dielectric oxide over the surface of the deposited electrically conductive layer;
c) repeating steps a) and b) for as many times as required to form said multilayered stack of the desired thickness.

6. A process for fabricating a multilayered stack useful for constituting the Seebeck-Peltier effect electrically conducting septum of claim 1, comprising the steps of

a) depositing with a CVD technique a polycrystalline conductor to form a first electrically conductive layer of mean thickness comprised between 5 and 40 nm on a substrate;
b) oxidizing the deposited polycrystalline conductor by exposing the deposited polycrystalline conductor to air at room temperature to promote growth of a layer of mean thickness comprised between 1 and 5 nm of sub-stoichiometric oxide over the surface of the deposited electrically conductive layer;
c) repeating steps a) and b) for as many times as required to form said multilayered stack of the desired thickness;
d) heating the multilayered stack for pyrolitically converting the sub-stoichiometric oxide to metal and dielectric oxide and forming a densely dispersed population of nano and sub-nano particles or clusters of particles at grain boundaries of the polycrystalline conductor matrix.

7. A process for fabricating a multilayered stack useful for constituting the Seebeck-Peltier effect electrically conducting septum of claim 5 or of claim 6, wherein said conductor is doped polycrystalline silicon deposited by feeding SiH4 mixed with a dopant precursor chosen among $PH_3$, $AsH_3$ and $B_2H_6$, and $N_2$ diluent, at a temperature comprised between 600 and 800 °C.

8. The process of claim 7 with the limitations of claim 6, wherein said pyrolitic treatment is carried out at a temperature of about 900-1000 °C for over 60 minutes.

9. A Seebeck-Peltier effect conversion device comprising a multilayered stack on a substrate, said stack constituting an electrically conductive septum with opposite hot-side and cold-side metallizations for connection to an electrical circuit, comprising a stacked succession of layers of electrically conductive material alternated to dielectric oxide layers in form of a continuous film or of densely dispersed nano particles and sub-nano particles or clusters of particles of oxide, al least said electrically conductive layers having mean thickness ranging from 5 to 100 nm and surface irregularities at the interfaces with the dielectric oxide layers of mean peak-to-valley amplitude and mean periodicity comprised between 5 to 20 nm.

**Patentansprüche**

1. Ein mehrlagiger Stapel, geeignet zur Bildung einer elektrisch leitenden Seebeck-Peltier-Effekt-Trennwand mit gegenüber liegenden Metallisierungen auf der heißen Seite und auf der kalten Seite zum Anschluss an einen elektrischen Schaltkreis, umfassend eine gestapelte Aufeinanderfolge von Schichten von elektrisch leitendem Material abwechselnd mit dielektrischen Oxidschichten, in Form eines kontinuierlichen Films oder dicht verteilter Nanopartikel und Sub-Nanopartikel oder Ansammlungen von Oxid-Partikeln, wobei wenigstens die besagten, elektrisch leitenden Schichten mittlere Stärken zwischen 5 und 100 nm aufweisen sowie Oberflächen-Unregelmäßigkeiten an den Zwischenflächen zu den dielektrischen Oxidschichten mit einer mittleren Spitze-zu-Tal-Weite und einer mittleren Periode in einem Bereich von 5 bis 20 nm.

2. Der mehrlagige Stapel nach Anspruch 1, wobei das besagte, elektrisch leitende Material ein dotierter Halbleiter ist aus der Gruppe, zusammengesetzt aus Si, Ge und Legierungen daraus.

3. Der mehrlagige Stapel nach Anspruch 1, wobei das besagte, elektrisch leitende Material dotiertes polykristallines Silizium ist und die besagte, dielektrische Oxidschicht ein oxidierter Oberflächenbereich des dotierten Polykristallins.

4. Der mehrlagige Stapel nach Anspruch 1, wobei das besagte, elektrisch leitende Material dotiertes polykristallines Silizium ist und das besagte, dielektrische Oxid ein unteroxidierter Oberflächenbereich des dotierten Polykristallins, welcher sukzessive pyrolytisch zu metallischem Silizium und dielektrischem Siliziumdioxid zerlegt wurde.

5. Ein Verfahren zur Herstellung eines mehrlagigen Stapels, geeignet zur Bildung der elektrisch leitenden Seebeck-Peltier-Effekt-Trennwand nach Anspruch 1, umfassend die folgenden Schritte:

   a) Abscheiden eines polykristallinen Leiters mittels einer CVD-Technik, um eine erste, elektrisch leitende Schicht mit einer mittleren Dicke zwischen 5 und 100 nm auf einem Substrat zu bilden;
   b) Oxidieren des abgeschiedenen polykristallinen Leiters durch Erhitzen auf etwa 1000 °C unter Sauerstoff, um ein unregelmäßiges Wachstum einer Schicht eines dielektrischen Oxids mit einer mittleren Dicke in einem Bereich zwischen 5 und 40 nm auf der Oberfläche der abgeschiedenen, elektrisch leitenden Schicht zu fördern;
   c) Wiederholen der Schritte a) und b) so oft als nötig, um den besagten mehrlagigen Stapel mit der gewünschten Stärke zu formen.

6. Ein Verfahren zur Herstellung eines mehrlagigen Stapels, geeignet zur Bildung der elektrisch leitenden Seebeck-Peltier-Effekt-Trennwand nach Anspruch 1, umfassend die folgenden Schritte:

   a) Abscheiden eines polykristallinen Leiters mittels einer CVD-Technik, um eine erste, elektrisch leitende Schicht mit einer mittleren Dicke zwischen 5 und 40 nm auf einem Substrat zu bilden;
   b) Oxidieren des abgeschiedenen polykristallinen Leiters durch Freilegen des abgeschiedenen polykristallinen Leiters an der Luft bei Zimmertemperatur, um das Wachstum einer Schicht eines sub-stöchiometrischen Oxids mit einer mittleren Dicke zwischen 1 und 5 nm über der Oberfläche der abgeschiedenen, elektrisch leitenden Schicht zu fördern;
   c) Wiederholen der Schritte a) und b) so oft als nötig, um den besagten mehrlagigen Stapel mit der gewünschten Stärke zu formen;
   d) Erhitzen des mehrlagigen Stapels zur pyrolytischen Umwandlung des sub-stöchiometrischen Oxids in ein Metall und ein dielektrisches Oxid und Bildung einer dicht verteilten Gesamtheit von Nano- und Sub-Nanopartikeln oder Ansammlungen von Partikeln an Korngrenzen der Matrix des polykristallinen Leiters.

7. Ein Verfahren zur Herstellung eines mehrlagigen Stapels, geeignet zur Bildung der elektrisch leitenden Seebeck-Peltier-Effekt-Trennwand nach Anspruch 5 oder 6, wobei der besagte Leiter dotiertes, polykristallines Silizium ist, welches abgeschieden wird durch Zuführen von SiH4, vermischt mit einem unter $PH_3$, $AsH_3$ und $B_2H_6$ ausgewählten Dotierungs-Precursor und einem $N_2$-Verdünnungsmittel bei einer Temperatur zwischen 600 und 800 °C.

8. Das Verfahren nach Anspruch 7 unter den Einschränkungen des Anspruchs 6, wobei die pyrolytische Behandlung bei einer Temperatur von etwa 900 - 1000 °C für mehr als 60 Minuten durchgeführt wird.

9. Ein Seebeck-Peltier-Umwandlungselement, umfassend einen mehrlagigen Stapel auf einem Substrat, wobei der besagte Stapel eine elektrisch leitende Trennwand mit gegenüber liegenden Metallisierungen auf der heißen Seite und auf der kalten Seite zum Anschluss an einen elektrischen Schaltkreis, umfassend eine gestapelte Aufeinanderfolge von Schichten von elektrisch leitendem Material abwechselnd mit dielektrischen Oxidschichten, in Form eines kontinuierlichen Films oder dicht verteilter Nanopartikel und Sub-Nanopartikel oder Ansammlungen von Oxid-Partikeln, wobei wenigstens die besagten, elektrisch leitenden Schichten mittlere Stärken aufweisen in einem Bereich von 5 bis 100 nm sowie mit Oberflächen-Unregelmäßigkeiten an den Zwischenflächen mit den dielektrischen Oxidschichten mit einer mittleren Spitze-zu-Tal-Weite und einer mittleren Periode in einem Bereich von 5 bis 20 nm.

**Revendications**

1. Empilement multicouches utile pour constituer un septum électriquement conducteur à effet Seebeck-Peltier avec des métallisations opposées côté chaud et côté froid pour le raccordement à un circuit électrique, comprenant une succession empilée de couches de matériau électriquement conducteur alternées avec des couches d'oxyde diélectrique sous la forme d'un film continu ou de particules nanométriques ou sous-nanométriques densément dispersées ou de clusters de particules d'oxyde, au moins lesdites couches électriquement conductrices ayant une épaisseur moyenne allant de 5 à 100 nm et des irrégularités de surface aux interfaces avec les couches d'oxyde diélectrique d'amplitude moyenne de pic à creux et de périodicité moyenne comprises entre 5 et 20 nm.

2. Empilement multicouches selon la revendication 1, dans lequel ledit matériau électriquement conducteur est un semi-conducteur dopé appartenant au groupe constitué par Si, Ge et des alliages de ceux-ci.

3. Empilement multicouches selon la revendication 1, dans lequel ledit matériau électriquement conducteur est un silicium polycristallin dopé et ladite couche d'oxyde diélectrique est une portion de surface oxydée du polycristallin dopé.

4. Empilement multicouches selon la revendication 1, dans lequel ledit matériau électriquement conducteur est un silicium polycristallin dopé et ledit oxyde diélectrique est une portion de surface sous-oxydée du silicium polycristallin dopé, décomposé successivement par pyrolyse en silicium métallique et en oxyde de silicium diélectrique.

5. Procédé de fabrication d'un empilement multicouches utile pour constituer le septum électriquement conducteur à effet Seebeck-Peltier selon la revendication 1, comprenant les étapes consistant à :

a) déposer par une technique CVD un conducteur polycristallin pour former une première couche électriquement conductrice d'une épaisseur moyenne comprise entre 5 et 100 nm sur un substrat ;
b) oxyder le conducteur polycristallin déposé par chauffage à environ 1000°C en oxygène pour favoriser la croissance irrégulière d'une couche d'une épaisseur moyenne comprise entre 5 et 40 nm d'oxyde diélectrique sur la surface de la couche électriquement conductrice déposée ;
c) répéter les étapes a) et b) autant de fois que nécessaire pour former ledit empilement multicouches d'épaisseur désirée.

6. Procédé de fabrication d'un empilement multicouches utile pour constituer le septum électriquement conducteur à effet Seebeck-Peltier selon la revendication 1, comprenant les étapes consistant à :

a) déposer par une technique CVD un conducteur polycristallin pour former une première couche électriquement conductrice d'une épaisseur moyenne comprise entre 5 et 40 nm sur un substrat ;
b) oxyder le conducteur polycristallin déposé par exposition du conducteur polycristallin déposé à un air à température ambiante pour favoriser la croissance d'une couche d'une épaisseur moyenne comprise entre 1 et 5 nm d'oxyde sous-stoechiométrique sur la surface de la couche électriquement conductrice déposée ;
c) répéter les étapes a) et b) autant de fois que nécessaire pour former ledit empilement multicouches d'épaisseur désirée ;
d) chauffer l'empilement multicouches pour convertir par pyrolyse l'oxyde sous-stoechiométrique en métal et oxyde diélectrique et former une population densément dispersée de particules nanométriques et sous-nanométriques ou de clusters de particules aux joints de grains de la matrice de conducteur polycristallin.

7. Procédé de fabrication d'un empilement multicouches utile pour constituer le septum électriquement conducteur à effet Seebeck-Peltier selon la revendication 5 ou la revendication 6, dans lequel ledit conducteur est un silicium polycristallin dopé déposé par alimentation du $SiH_4$ mélangé à un précurseur dopant choisi parmi $PH_3$, $AsH_3$ et $B_2H_6$, et un diluant $N_2$, à une température comprise entre 600 et 800°C.

8. Procédé selon la revendication 7 avec les limitations de la revendication 6, dans lequel ledit traitement de pyrolyse est réalisé à une température d'environ 900 à 1000°C pendant plus de 60 minutes.

9. Dispositif de conversion à effet Seebeck-Peltier comprenant un empilement multicouches sur un substrat, ledit empilement constituant un septum électriquement conducteur avec des métallisations opposées côté chaud et côté froid pour le raccordement à un circuit électrique, comprenant une succession empilée de couches de matériau électriquement conducteur alternées avec des couches d'oxyde diélectrique sous la forme d'un film continu ou de particules nanométriques ou sous-nanométriques densément dispersées ou de clusters de particules d'oxyde, au moins lesdites couches électriquement conductrices ayant une épaisseur moyenne allant de 5 à 100 nm et des irrégularités de surface aux interfaces avec les couches d'oxyde diélectrique d'amplitude moyenne de pic à creux et de périodicité moyenne comprises entre 5 et 20 nm.

C6 D5 C5 D4 C4 D3 C3 D2 C2 D1 C1 S

Fig.1

Fig.2

## REFERENCES CITED IN THE DESCRIPTION

**Patent documents cited in the description**

- WO 2009125317 A
- IT VA20090082 A
- IT VA20090050 A
- EP 2010069531 W